# FASCICULE DE BREVET EUROPEEN

(11) **EP 2 693 140 B1**
(45) Date de publication et mention de la délivrance du brevet: **07.03.2018**
(21) Numéro de dépôt: 13177983.7
(22) Date de dépôt: 25.07.2013
(51) Int. Cl.: F25B 21/00, H01L 23/34, H05K 7/20

(54) **Procédé de limitation des variations de température d'un composant électrique**
Verfahren zur Begrenzung der Temperaturschwankungen eines elektrischen Bauteils
Method for limiting the temperature variations of an electric component

(30) Priorité: 03.08.2012 FR 1257586
(43) Date de publication de la demande: 05.02.2014
(73) Titulaire: Commissariat à l'Énergie Atomique et aux Énergies Alternatives, 75015 Paris (FR)
(72) Inventeur: Defay, Emmanuel, 38340 Voreppe (FR); Mathur, Neil, Cambridge CB4 3PU (GB); Kar-Narayan, Sohini, Cambridge CB3 9BG (GB); Soussi, Jordane, 83100 Bordeaux (FR)
(74) Mandataire: Colombo, Michel

(56) Documents cités:
- US-A- 5 569 950
- US-A1- 2011 146 308
- US-B1- 6 877 325
- "Simulation of a solid state cooler with electrocaloric elements", PHYSICS OF THE SOLID STATE, AMERICAN INSTITUTE OF PHYSICS, WOODBURY, NY, US, vol. 51, 30 août 2009 (2009-08-30), pages 1574-1577, XP009164935, ISSN: 1063-7834

## Description

L'invention concerne un procédé de limitation des variations de température d'un composant électrique. L'invention concerne également un support d'enregistrement d'informations ainsi qu'un système électronique pour la mise en oeuvre de ce procédé.

Pour chaque composant électrique, le constructeur spécifie une plage nominale de température de fonctionnement et, en particulier, une température maximale Tₘₐₓ de fonctionnement. Si la température du composant est au-dessus de cette température Tₘₐₓ, alors le composant peut s'abîmer ou ses performances sont dégradées. Il est donc important d'essayer de maintenir la température du composant électrique en dessous de cette température Tₘₐₓ.

Pour cela, il a déjà été proposé de refroidir le composant électrique par divers dispositifs comme un radiateur, un liquide caloporteur ou autre.

Récemment, il a été suggéré qu'il était possible d'utiliser un matériau électrocalorique pour pomper la chaleur d'un point chaud vers un point froid. Toutefois, cela suppose l'utilisation d'interrupteurs thermiques pour garantir que la chaleur s'écoule toujours dans le même sens. Par exemple, cela est divulgué dans l'article A1 suivant :
S. Kar-Narayan et N.D. Mathur, « Predicted cooling powers for multilayer capacitors based on various electrocaloric and electrode materials », Applied Physics Letters 95, 242903 (2009).

De l'état de la technique est également connu de :
- US 5 569 950 A,
- « Simulation of a solid state cooler with electrocaloric elements », Physics of the solid state, American Institute of Physics, Woodbury, NY, US, Vol. 51, 30/08/2009, pages 1574-1577,
- US 6 877 325 B1,
- US 2011/146308 A1.

L'invention vise à proposer un procédé plus simple pour limiter les variations de température d'un composant électrique et, notamment, un procédé qui ne nécessite pas l'utilisation d'interrupteurs thermiques.

Elle a donc pour objet, un procédé de limitation des variations de température d'un composant électrique équipé d'une face d'évacuation de la chaleur, ce procédé étant conforme à la revendication 1.

Dans le cas d'un matériau électrocalorique positif, sa température augmente quand une différence de potentiels est appliquée entre les électrodes. Par conséquent, l'application de la première différence de potentiels augmente la température du composant électrique lorsque celui-ci est dans son état passif. Toutefois, cette augmentation de la température du composant électrique dans l'état passif ne pose pas de problème car dans cet état, le composant électrique est loin de sa température maximale Tₘₐₓ.

La diminution de la différence de potentiels du condensateur dans l'état actif provoque une baisse de la température du condensateur, ce qui permet de refroidir le composant électrique lorsque celui-ci produit de la chaleur. On évite donc ou on ralentit ainsi le temps mis par le composant électrique pour atteindre sa température maximale Tₘₐₓ. Ainsi, la commande du condensateur comme décrite dans le procédé ci-dessus permet d'amortir et de limiter les variations de température du composant électrique. En faisant cela, il est possible d'empêcher que la température du composant ne dépasse la température Tₘₐₓ sans pour autant utiliser des interrupteurs thermiques.

Dans le cas d'un matériau électrocalorique négatif, sa température décroît quand une différence de potentiels est appliquée entre les électrodes. Le procédé ci-dessus permet aussi de limiter les variations de température du composant électrique en utilisant un matériau électrocalorique négatif. Toutefois, dans ce cas, la valeur absolue de la première différence de potentiels est strictement inférieure à la valeur absolue de la seconde différence de potentiels.

Les modes de réalisation de ce procédé peuvent comporter une ou plusieurs des caractéristiques des revendications dépendantes de procédé.

Les modes de réalisation de ce procédé présentent en outre les avantages suivants :
- le passage de la première différence de potentiels vers la seconde différence de potentiels dans un intervalle de temps dont la durée est fonction d'une estimation de la durée de l'état actif permet de lisser encore plus les variations de température du composant électrique ;
- à l'inverse, le passage brusque, c'est-à-dire en moins de 100 ms, de la première à la deuxième différence de potentiels permet de sauvegarder ou au moins de retarder l'instant auquel le composant électrique dépasse la température Tₘₐₓ.

L'invention a également pour objet un support d'enregistrement d'informations comportant des instructions pour l'exécution du procédé ci-dessus, lorsque ces instructions sont exécutées par un calculateur électronique.

L'invention a également pour objet un système électronique conforme à la revendication 7.

Les modes de réalisation de ce système électronique peuvent comporter une ou plusieurs des caractéristiques des revendications dépendantes de système.

L'invention sera mieux comprise à la lecture de la description qui va suivre, donnée uniquement à titre d'exemple non limitatif et faîte en se référant aux dessins sur lesquels :
- la figure 1 représente un terminal équipé d'un système électronique dans lequel est refroidi un composant électrique,
- la figure 2 est un organigramme d'un procédé de limitation des variations de température du composant électrique du système de la figure 2,
- la figure 3 est un chronogramme illustrant la variation de température d'un condensateur du système de la figure 1 en fonction du temps,
- la figure 4 représente des chronogrammes illustrant, respectivement, la variation de température du composant électrique du système de la figure 1 au cours du temps et l'évolution d'une différence de potentiels au cours du temps aux bornes d'un condensateur du système de la figure 1,
- la figure 5 est un organigramme d'un procédé de fabrication d'un condensateur pour le système de la figure 2,
- les figures 6 à 12 sont des illustrations schématiques et en coupe verticale de différentes étapes de fabrication du condensateur du système de la figure 1 ;
- la figure 13 est une illustration schématique d'un autre mode de réalisation d'un système électronique dans lequel un composant électrique est refroidi ;
- la figure 14 est un organigramme d'un procédé de refroidissement du composant électrique de la figure 13.

Dans ces figures, les mêmes références sont utilisées pour désigner les mêmes éléments.

Dans la suite de cette description, les caractéristiques et fonctions bien connues de l'homme du métier ne sont pas décrites en détail.

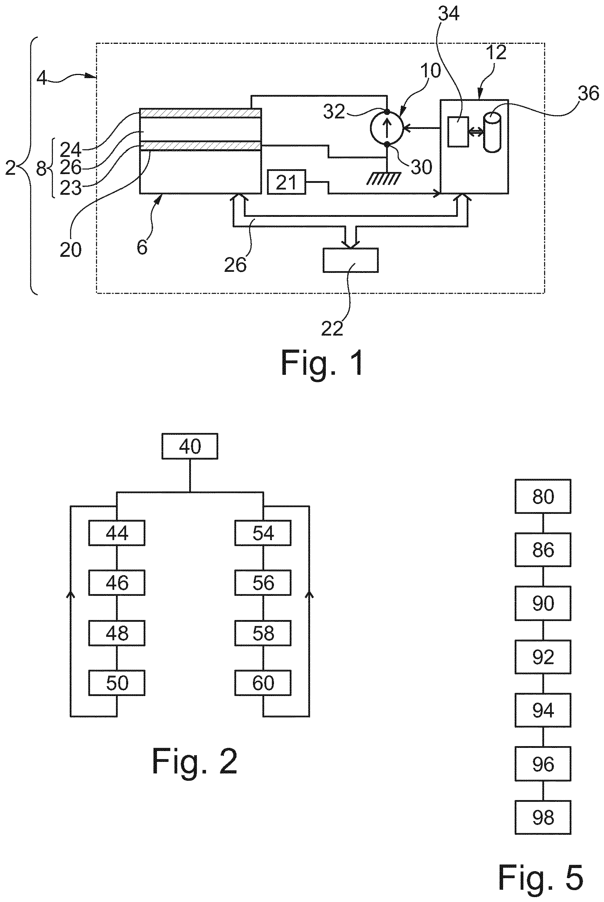

La figure 1 représente un terminal 2. Par exemple, le terminal 2 est un terminal mobile tel qu'un téléphone portable.

Le terminal 2 comprend un système électronique 4 tel qu'un émetteur-récepteur, un microcontrôleur ou autre.

Le système 4 comprend :
- un composant électrique 6,
- un condensateur 8 pour refroidir le composant électrique 6,
- une source de tension 10 commandable, et
- une unité 12 de commande.

Le composant 6 est ici un composant électronique et, plus précisément, un circuit intégré. Typiquement ce circuit intégré comprend une multitude de commutateurs électroniques commandables aptes chacun à basculer entre une position ouverte et une position fermée pour réaliser une fonction prédéfinie. Dans la position ouverte, le commutateur laisse difficilement passer le courant. A l'inverse, dans la position fermée, le commutateur laisse facilement passer le courant. Lors de chaque commutation entre les positions ouverte et fermée, une partie de l'énergie électrique reçue par le commutateur est transformée en chaleur. Dans la position fermée, une partie de l'énergie qui traverse le commutateur peut aussi être transformée en chaleur si ce commutateur présente une résistance non nul dans cette position. Par conséquent, le composant 6 produit de la chaleur quand il est utilisé. A l'inverse, il n'en produit pas lorsqu'il n'est pas utilisé.

Quand le composant 6 doit être refroidi, on dit qu'il est dans l'état actif. Au contraire, quand le composant 6 peut être réchauffé, on dit qu'il est dans l'état passif. Le basculement entre ces états passif et actif est détecté à partir de valeurs acquises de la quantité Q de chaleur produite par seconde par le composant 6 et/ou à partir de valeurs acquises de la température T du composant 6. Dans ce premier mode de réalisation, l'état actif est détecté dès que le composant 6 produit une quantité Q de chaleur par seconde supérieure à un seuil prédéterminé Q₁. exprimé en Watt, et que sa température T est supérieure à un seuil prédéterminé T₁. Au contraire, quand le composant 6 produit une quantité Q de chaleur par seconde inférieure à ce seuil Q₁ ou a une température T inférieure au seuil T₁, on détecte que le composant est dans l'état passif.

Typiquement, dans l'état passif, le composant 6 n'est pas utilisé ou très peu utilisé. Par très peu utilisé, on désigne par exemple la situation où le composant 6 est en veille.

Le composant 6 est commandable et peut être basculé, en alternance, entre son état actif et son état passif.

Ici, le composant 6 est associé à une température maximale Tₘₐₓ. Typiquement, la température Tₘₐₓ correspond à une température au-delà de laquelle le composant 6 risque d'être endommagé ou au-delà de laquelle ses performances se dégradent. Le seuil T₁ est strictement inférieur à cette température Tₘₐₓ.

Ici, la valeur du seuil Q₁ est choisie strictement supérieure à zéro et, par exemple, supérieur à 0,1mW ou 1mW ou 10mW.

Le composant 6 est conçu pour que l'essentiel de la chaleur qu'il produit soit évacuée par l'intermédiaire d'une face 20 d'évacuation de chaleur. Ici, la face 20 est la face supérieure du composant 6.

Un capteur 21 est prévu pour mesurer la température T du composant 6. Ce capteur 21 est raccordé à l'unité 12.

Le composant 6 bascule entre ses états actif et passif en réponse à des événements extérieurs acquis par l'intermédiaire d'une interface 22. Ici, c'est la réception de ces événements qui est utilisée pour détecter que la quantité Q de chaleur produite par seconde est supérieure au seuil Q₁. Autrement dit, la réception de ces événements est utilisée comme étant une grandeur physique représentative de la quantité de chaleur produite par seconde par le composant 6. Plus précisément, dans ce mode de réalisation la réception d'un événement déclenchant un fonctionnement intensif du composant 6 indique que la quantité de chaleur qu'il produit pas seconde dépasse le seuil Q₁. A l'inverse, dès qu'un événement arrêtant le fonctionnement intensif ou mettant en veille le composant 6 est reçu sur l'interface 22, on considère que la quantité Q est inférieure au seuil Q₁. Cette façon de procéder permet d'éviter d'avoir recours à un capteur de quantité de chaleur produite par seconde.

Par exemple, l'interface 22 est une interface homme-machine ou une prise de raccordement à un réseau de transmission d'informations ou autre. L'interface 22 est raccordée au composant 6 par l'intermédiaire d'un bus 26 de transmission d'informations.

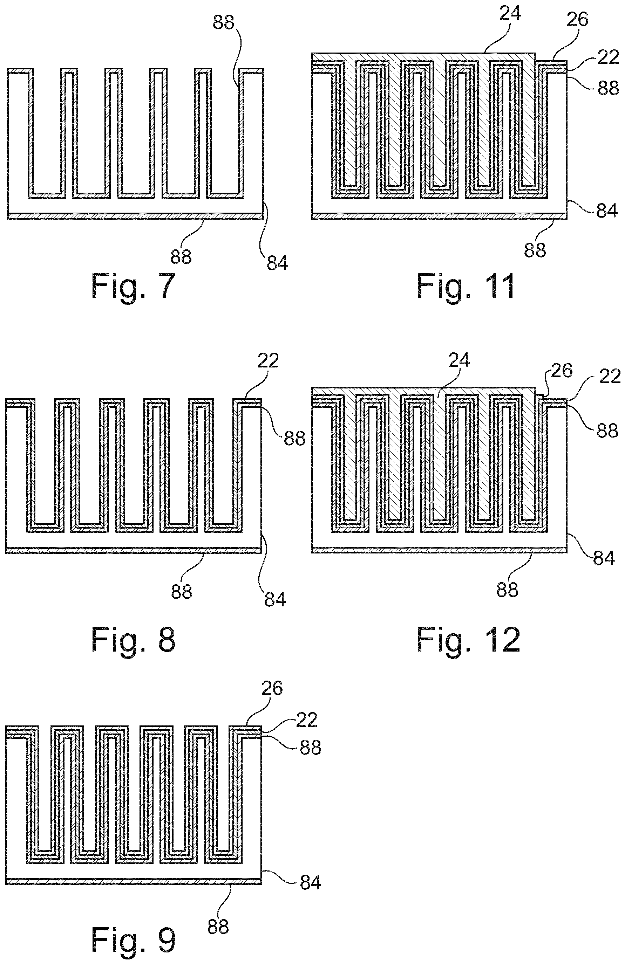

La structure du condensateur 8 est uniquement représentée schématiquement sur la figure 1. Un mode de réalisation plus détaillé de cette structure est représenté sur la figure 12.

Le condensateur 8 comporte deux électrodes métalliques 23, 24 isolées mécaniquement et électriquement l'une de l'autre par une couche 26 en matériau diélectrique. En plus d'être réalisé dans un matériau bon conducteur électrique, les électrodes 23 et 24 sont également réalisées dans un matériau bon conducteur thermique. Dans cette description, on considère qu'un matériau est bon conducteur thermique si sa conductivité thermique à 22°C est supérieure à 2 W.m⁻¹.K⁻¹ et, de préférence, supérieure à 10 ou 50 W.m⁻¹.K⁻¹. Par exemple, les électrodes 23, 24 sont réalisées en métal tel que du platine, du nickel, de l'or, du cuivre, de l'argent ou du palladium. De préférence, ces électrodes sont réalisées à l'aide d'un alliage à base d'oxyde. Par exemple, de préférence, les électrodes sont réalisées en RuO₂, SiRuO₃, IrO₃ ou LaNiO₃. En effet, la saturation en oxygène de ces électrodes permet de limiter la fatigue et l'usure du condensateur.

Les électrodes 23 et 24 se présentent sous la forme d'une couche d'épaisseur eₑ sensiblement constante. Typiquement, l'épaisseur eₑ est supérieure à 10 nm ou 0,1 µm et inférieure à 10 µm ou 5 µm.

L'électrode 23 est en contact thermique par conduction avec la face 20 pour refroidir le composant 6. On considère qu'il y a un contact thermique par conduction :
a) si l'électrode 23 est directement en contact mécanique et thermique avec la face 20, ou
b) si l'électrode 23 est thermiquement reliée à la face 20 par l'intermédiaire d'un matériau bon conducteur thermique.

De préférence, dans le cas a) ou b) ci-dessus, la section transversale traversée par la chaleur qui se propage de la face 20 jusqu'à l'électrode 23 est supérieure à au moins la moitié de la surface de la face 20 et, de préférence, au moins égale à la surface de la face 20.

Dans ce mode de réalisation, l'électrode 23 est directement en contact mécanique sur toute la surface de la face 20.

Pour permettre de refroidir le composant 6, la couche 26 est réalisée dans un matériau qui est à la fois diélectrique et électrocalorique. Un matériau électrocalorique est un matériau dont la température change brusquement en réponse à l'application d'un champ électrique.

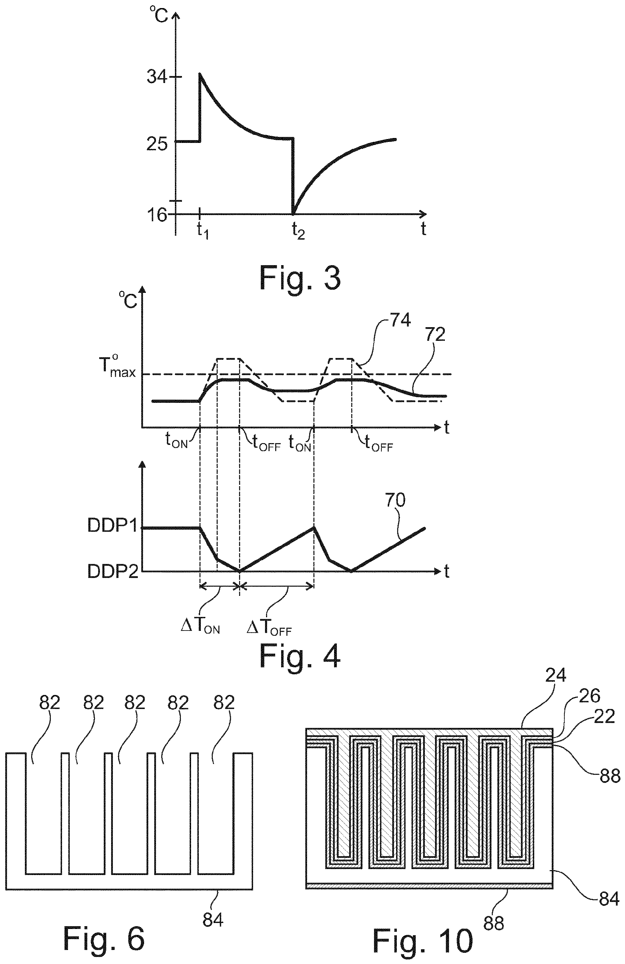

Le comportement d'un matériau électrocalorique positif en réponse au champ électrique est illustré sur la figure 3. La température du matériau est initialement égale à la température ambiante, c'est-à-dire dans le cas illustré sur la figure 3 à 25°C. Dans l'état initial, le matériau électrocalorique n'est pas placé à l'intérieur d'un champ électrique.

A l'instant t₁, un champ électrique est appliqué. Cela provoque immédiatement une augmentation ΔT de la température de ce matériau de plusieurs degrés. Dans le cas illustré, ΔT est égal à 9°C. Ensuite, le champ électrique est maintenu constant entre les instants t₁ et t₂. Dans ces conditions, la température du matériau électrocalorique diminue par échange de chaleur avec l'environnement extérieur jusqu'à ce que sa température devienne égale à la température ambiante de l'environnement extérieur.

A l'instant t₂, le champ électrique est supprimé lorsque la température du matériau électrocalorique est redevenue égale à la température ambiante. En réponse, la température du matériau électrocalorique baisse immédiatement de - ΔT. Ensuite, la température du matériau électrocalorique augmente par échange de chaleur avec l'environnement extérieur jusqu'à redevenir égale à la température ambiante. On est alors revenu dans l'état initial. Comme l'illustre le schéma de la figure 3, un matériau électrocalorique est donc utilisable pour réchauffer ou refroidir temporairement un composant électrique.

Ici, le matériau électrocalorique dont le fonctionnement vient d'être décrit est un matériau électrocalorique « positif », c'est-à-dire que sa température augmente quand on applique un champ électrique. Il existe aussi des matériaux électrocaloriques négatifs dont la température diminue quand on applique un champ électrique. Dans ce mode de réalisation, la couche 26 est réalisée dans un matériau électrocalorique positif.

Les matériaux électrocaloriques sont bien connus depuis longtemps. Toutefois, ce n'est que récemment qu'il a été découvert que les performances de ces matériaux électrocaloriques pouvaient être considérablement améliorées si on les utilisait sous forme de couches minces. Ici, on considère qu'une couche en matériau est mince si son épaisseur est inférieure à 500 µm ou 50 µm et, de préférence, inférieure à 15 µm ou 10 µm ou 5 µm. On pourra se référer à ce sujet à l'article A2 suivant :
A.F. Mischenko, Q. Zhang, J.F. Scott, R.W. Whatmore, N.D. Mathur, « Giant electrocaloric effect in thin-film PbZr0,95 Ti0,05O3 », 3 mars 2006, volume 311, science.

Plus récemment encore, il a été mis en évidence que l'on pouvait atteindre des variations ΔT de température proche de 40°C dans certains matériaux électrocaloriques. On peut se référer à ce sujet à l'article A3 suivant :
S.G. Lu, B.R. Rozic, Q.M. Zhang, Z.Kutnjak, Xinyu Li, E.Furman, Lee J. Gorny et al. « Organic and inorganic relaxor ferroelectrics with giant electrocaloric effect », Applied Physics Letters 97, 162904 (2010).

Dans cette description, on considère que la couche 26 est réalisée en matériau électrocalorique si sa variation maximale ΔTmax de température en réponse à un champ électrique est au moins de 5°C et, de préférence, d'au moins 10°C.

La variation ΔTₘₐₓ de température se produit à proximité d'une température, appelée ici « température de transition ». Cette température de transition est différente pour chaque matériau électrocalorique. La température de transition de chaque matériau électrocalorique est connue. Par exemple, on pourra se référer à ce sujet à la table 1 de l'article A3 pour quelques exemples de valeurs de température de transition.

Ici, le matériau de la couche 26 est choisi pour présenter une température de transition égale à une température Tₐ à plus ou moins 5 ou 2,5 ou une fois la variation ΔTₘₐₓ de ce matériau près. La température Tₐ est la température autour de laquelle on souhaite stabiliser la température du composant 6. La température Tₐ correspond souvent à la température ambiante de l'environnement extérieur. Ici, on suppose donc que cette température Tₐ est égale à 25°C. A titre d'illustration seulement, cela peut donc conduire à choisir comme matériau électrocalorique, le [Pb(Mg_{1/3}Nb_{2/3})O₃]_{0,93}-[PbTiO₃]_{0,07}. Ce matériau est par exemple décrit plus en détail dans l'article A4 suivant :
T.M. Correia, J.S. Young, R.W. Whatmore, J.F. Scott, N.D. Mathur et Q. Zhang, Applied Physics Letters 95, 182904 (2009).

Toutefois, pour d'autres températures Tₐ, d'autres choix sont possibles pour le matériau électrocalorique. Typiquement, le matériau électrocalorique de la couche 26 est choisi dans le groupe comprenant ou composé de :
- Pb(Zr,Ti)O₃ connu sous l'acronyme PZT,
- (Pb,La)(Zr,Ti)O₃ connu sous l'acronyme de PLZT,
- Pb(Mg,Nb,Ti)O₃ connu sous l'acronyme de PMN-PT,
- (Ba,Sr)TiO₃ connu sous l'acronyme de BST,
- SrBi₂Ta₂O₉ connu sous l'acronyme de SBT,
- PVDF (Polyfluorure de vinylène) tel que le P(VDF-TrFE) ou P(VDF-TrFE-CFE).

Pour avoir à la fois une grande capacité à absorber de la chaleur avec une couche mince en matériau électrocalorique, il a été proposé d'agencer les électrodes 23 et 24 et la couche 26 sous forme d'un condensateur multicouche plus connu sous l'acronyme MLC (Multi-Layer Capacitor). On pourra se référer à ce sujet à l'article A1.

Ici, le condensateur 8 est un condensateur multicouche dont l'épaisseur de la couche 26 est inférieure à 5 ou 2µm. Par exemple, l'épaisseur de la couche 26 est comprise entre 10 nm et 10 µm et, de préférence, entre 10 nm et 2 µm ou entre 100 nm et 2 µm.

Les électrodes 23 et 24 sont électriquement raccordées à des bornes 30, 32 respectives de la source 10 de tension. Dans ces conditions, la source 10 permet d'appliquer une différence de potentiels entre les électrodes 23 et 24 pour générer le champ électrique qui fait varier la température de la couche 26. Ici, la borne 30 est raccordée à la masse. La différence de potentiels générée par la source 10 est donc égale à la tension V₀ générée entre la borne 32 et la masse.

La source 10 est commandable par l'unité 12 pour faire varier la différence de potentiels appliquée entre les électrodes 23 et 24 entre deux valeurs extrêmes, notées, respectivement DDP1 et DDP2. Ici, la valeur DDP1 est strictement positive et la valeur DDP2 est égale à 0 V. Par exemple, la valeur DDP1 est supérieure à 4 Vdc.

L'unité 12 est programmée pour exécuter le procédé de la figure 2. A cet effet, elle comporte un calculateur électronique 34 programmable apte à exécuter des instructions enregistrées sur un support d'enregistrement d'informations. Elle comporte donc une mémoire 36 raccordée au calculateur 34 et contenant les instructions nécessaires pour l'exécution du procédé de la figure 2.

De plus, l'unité 12 est raccordée à la source 10 pour commander la valeur de la tension V₀. Elle est également raccordée au bus 26 pour acquérir les événements qui permettent de détecter le basculement du composant 6 de l'état actif vers l'état passif et vice versa.

Le fonctionnement du système 4 va maintenant être décrit à l'aide du procédé de la figure 2.

Initialement, lors d'une étape 40, l'unité 12 acquiert deux estimations EDₒₙ et ED_{off}. Les estimations EDₒₙ et ED_{off} sont des estimations, respectivement, de la durée des intervalles de temps IDₒₙ et ID_{off}. L'intervalle IDₒₙ est l'intervalle de temps pendant lequel le composant 6 est constamment dans l'état actif. L'intervalle ID_{off} est l'intervalle de temps pendant lequel le composant 6 est constamment dans l'état passif. Ces estimations EDₒₙ et ED_{off} sont construites à partir de mesures précédentes de durée des intervalles IDₒₙ et ID_{off}.

Ensuite, lors d'une étape 44, le composant 6 reçoit un événement d'activation à un instant tₒₙ. Cet événement est reçu par l'intermédiaire de l'interface 22 et du bus 26.

Lors d'une étape 46, immédiatement en réponse, le composant 6 passe dans un mode de fonctionnement intensif. Ensuite, il reste dans ce mode de fonctionnement intensif pendant toute la durée de l'intervalle de temps IDₒₙ. Typiquement, cet intervalle de temps dure plus 1 ms et, généralement, plus de 100 ms ou 1s. Sa durée est par contre généralement inférieure à une heure ou 5 minutes.

Ensuite, lors d'une étape 48, le composant 6 reçoit un événement de désactivation à un instant t_{off}. Cet événement est reçu par l'intermédiaire de l'interface 22 et du bus 26.

Lors d'une étape 50, immédiatement en réponse, le composant 6 passe en veille. Ensuite, il reste en veille pendant toute la durée de l'intervalle ID_{off}. La durée de l'intervalle ID_{off} est généralement supérieure ou égale à la durée de l'intervalle IDₒₙ. En veille, les échanges thermiques avec l'environnement extérieur sont suffisants pour faire diminuer sa température jusqu'à ce que celle-ci se stabilise autour de la température ambiante.

A l'issue de l'étape 50, le procédé retourne à l'étape 44. Ainsi, puisque les événements d'activation et de désactivation sont reçus en alternance, le composant 6 alterne régulièrement entre un mode de fonctionnement intensif et la veille.

En parallèle, lors d'une étape 54, à l'instant tₒₙ, l'unité 12 détecte le basculement vers l'état actif. Pour cela, ici, elle détecte la réception de l'événement d'activation et acquière la température mesurée par le capteur 21. La réception de l'événement d'activation est interprétée comme signifiant que la quantité Q de chaleur produite par seconde par le composant 6 est supérieure au seuil Q₁. Si la température est inférieure au seuil T₁, le basculement vers l'état actif n'est pas détecté. Dans ce cas, l'unité 12 acquière à intervalle régulier la température T pour détecter un basculement ultérieur du composant 6 vers l'état actif. Si la température T acquise est supérieure au seuil T₁, l'état actif du composant 6 est détecté. En réponse à cette détection, l'unité 12 commande la source 10 pour diminuer la différence de potentiels entre les électrodes 23 et 24. Cette diminution de la différence de potentiels provoque une baisse de la température du matériau électrocalorique qui est transmise, par conductivité thermique, au composant électrique 6. Cette baisse de température limite ou annule l'augmentation de la température du composant 6 lorsque celui-ci est dans son état actif.

Dans ce mode de réalisation, l'unité 12 diminue progressivement la différence de potentiels suivant une fonction monotone décroissant continûment pendant toute la durée d'un intervalle de temps ΔTₒₙ. Ici, la durée de l'intervalle ΔTₒₙ est déterminée en fonction de l'estimation EDₒₙ. Par exemple, dans ce cas particulier, la durée de l'intervalle ΔTₒₙ est prise égale à la valeur de l'estimation EDₒₙ.

Il n'est pas nécessaire que la différence de potentiels diminue linéairement pendant toute la durée de l'intervalle ΔTₒₙ de la valeur DDP1 à la valeur DDP2. Par exemple, ici, la différence de potentiels diminue plus rapidement pendant le premier tiers de l'intervalle ΔTₒₙ que pendant le dernier tiers de l'intervalle ΔTₒₙ. Une telle stratégie pour contrôler la différence de potentiels permet d'éviter une brusque baisse de la température du composant 6 immédiatement après son passage dans l'état actif.

L'aptitude du condensateur à absorber de la chaleur et donc à diminuer la température du composant 6 d'une façon significative est illustrée par l'exemple numérique suivant. La quantité de chaleur maximale absorbée par le condensateur 8 est donnée par la relation suivante : ΔQₘₐₓ=mCΔT, où :
- C est la capacité calorifique par unité de masse de la couche 26,
- m est la masse de la couche 26,
- ΔT est la variation de température de la couche 26 en réponse à l'application d'une différence de potentiels entre les électrodes 23 et 24 égale à DDP1-DDP2.

Par exemple, C est égal à 350 J.K⁻¹.kg⁻¹. La densité du matériau de la couche 26 est égale à 7000 Kg/m³. Le volume total de la couche 26 est égal à 1 mm³ et la variation de température ΔT est égale à 10°C. Par conséquent, la quantité maximale de chaleur qui peut être absorbée par la couche 26 est de 25 mJ. Si l'on suppose que la durée de l'intervalle IDₒₙ est d'une seconde et d'autre part que la surface de la face 20 est de 1 mm², le condensateur 8 peut absorber pendant cette seconde une densité de puissance de 2,5 W/cm². Autrement dit, cela signifie que si le composant 6 produit 2,5 W/cm² pendant une seconde, celui-ci gardera une température constante si le condensateur 8 est activé. Si le composant 6 est en silicium et que son volume est de 1 mm³ sans activation du condensateur 8, sa variation de température atteindrait 7,5°C. Si le condensateur 8 est activé pendant que le composant 6 produit 25 mJ pendant une seconde, la variation de température du composant 6 est annulée.

Ensuite, lors d'une étape 56, quand la différence de potentiels entre les électrodes 23 et 24 atteint la valeur DDP2, l'unité 12 maintient la différence de potentiels égale à cette valeur DDP2 tant que le basculement du composant 6 vers l'état passif n'est pas détecté.

Ensuite, lors d'une étape 58, l'unité 12 détecte le basculement du composant 6 de l'état actif vers l'état passif. Comme lors de l'étape 54, pour cela, l'unité 12 détecte la réception de l'événement de désactivation du composant 6 à l'instant t_{off}. En même temps, l'unité 12 acquière la valeur mesurée par la capteur 21. Tant que la valeur mesurée de la température T est supérieure au seuil T₁, le basculement dans l'état passif n'est pas détecté.

A l'inverse, dès que la valeur mesurée de la température T descend en-dessous du seuil T₁, le basculement dans l'état passif est détecté. En réponse, l'unité 12 commande la source 10 pour augmenter à nouveau la différence de potentiels entre les électrodes 23 et 24. Cette augmentation provoque une augmentation de la température de la couche 26 et, par conductivité thermique, limite la diminution de la température du composant 6. Dans ce mode de réalisation, l'unité 12 augmente progressivement la différence de potentiels de la valeur DDP2 à la valeur DDP1 en suivant une fonction monotone croissante pendant toute la durée de l'intervalle ΔT_{off}. Ici, la durée de l'intervalle ΔT_{off} est obtenue en fonction de l'estimation ED_{off}. Par exemple, dans ce mode de réalisation, la durée de l'intervalle ΔT_{off} est égale à l'estimation ED_{off}. A titre d'illustration, la différence de potentiels croît linéairement de la valeur DDP2 à la valeur DDP1 pendant toute la durée de l'intervalle ΔT_{off}.

Lors d'une étape 60, quand la différence de potentiels atteint à nouveau la valeur DDP1, l'unité 12 maintient cette différence de potentiels à cette valeur tant que le composant 6 reste dans l'état passif. On retourne alors à l'étape 54.

La figure 4 représente deux chronogrammes l'un au-dessus de l'autre. Dans le chronogramme du dessous, une ligne 70 représente l'évolution au cours du temps de la valeur de la différence de potentiels entre les électrodes 23 et 24 lorsque le procédé de la figure 2 est mis en oeuvre. La ligne 70 est dessinée dans le cas particulier où la valeur DDP2 est atteinte à l'instant t_{off} et la valeur DDP1 est atteinte à l'instant ΔTₒₙ. Dans ce cas particulier, les étapes 56 et 60 sont omises.

Dans le chronogramme du dessus, une ligne en trait plein 72 représente l'évolution de la température du composant 6 lorsque le procédé de la figure 2 est mis en oeuvre. Une ligne 74 en pointillés représente la température du composant 6 dans le cas où le procédé de la figure 2 n'est pas mis en oeuvre. Comme le montre la ligne 74, si le procédé de la figure 2 n'est pas mis en oeuvre, la température du composant 6 dépasse la température Tₘₐₓ. A l'inverse, si le procédé de la figure 2 est mis en oeuvre, la température du composant 6 ne dépasse pas cette température Tₘₐₓ.

On notera également que la valeur moyenne de la température du composant 6 sur plusieurs intervalles IDₒₙ et ID_{off} successifs est la même que le procédé de la figure 2 soit mis en oeuvre ou non. Ainsi, le procédé de la figure 2 permet de limiter les variations de température du composant 6 mais ne permet pas de diminuer sa température moyenne sur une longue durée.

La figure 5 représente un procédé particulier de fabrication du condensateur 8. Ce procédé permet notamment de diminuer l'épaisseur de la couche 26 pour que celle-ci soit comprise entre 10 nm et 2 µm. En effet, décroître l'épaisseur de la couche 26 permet de décroître la valeur DDP1 à appliquer entre les électrodes 23 et 24 ce qui simplifie la réalisation du système 4. De plus, ce procédé permet de réaliser le condensateur 8 sur un même substrat que le composant 6. Ce procédé va maintenant être décrit également en référence aux figures 6 à 12.

Lors d'une étape 80, des tranchées 82 (figure 6) sont gravées dans un substrat 84. Par exemple, le substrat 84 est un substrat plan en silicium. La largeur des tranchées est typiquement comprise entre 0,5 et 30 µm et, de préférence, inférieure à 5 ou 2 µm. Ici, les largeurs des tranchées sont égales à 1 µm. La section transversale des tranchées 82 peut être quelconque. Par exemple, elle peut être circulaire ou rectangulaire.

La profondeur des tranchées est typiquement comprise entre 1 µm et 500 µm et, de préférence, entre 50 µm et 100 µm. Ici, la profondeur est égale à 100 µm.

La gravure des tranchées 82 est réalisée par une méthode de gravure profonde utilisant une technique anisotrope. Par exemple, il peut s'agir d'une alternance de gravures SF6 et de passivation des flancs verticaux C4F8. Ce procédé est appelé procédé Bosch.

Ensuite, lors d'une étape 86, on réalise une couche barrière 88 (figure 7) pour empêcher la diffusion non souhaitée d'espèces chimiques vers le substrat 84. Par exemple, la couche barrière 88 est réalisée par une oxydation thermique du substrat. L'épaisseur de cette couche barrière 88 est typiquement comprise entre 10 nm et 5 µm et, de préférence, entre 50 nm et 150 nm. Ici, l'épaisseur est égale à 100 nm.

Lors d'une étape 90, l'électrode 23 (figure 8) est déposée. Le dépôt de l'électrode est réalisé par exemple à l'aide de techniques telles qu'un dépôt CVD (Chemical Vapor Deposition) ou ALD (Atomic Layer Deposition). Ici, l'épaisseur de l'électrode 23 est comprise entre 10 nm et 5 µm. Dans ce cas, elle est égale à 100 nm.

Lors d'une étape 92, la couche 26 (figure 9) est déposée. La méthode utilisée pour déposer la couche 26 dépend du matériau électrocalorique choisi. Par exemple, la méthode de dépôt peut être une méthode connue sous l'acronyme de MOCVD (Metal Organic Chemical Vapor Deposition) ou ALD (Atomic Layer Deposition). Le dépôt peut également être réalisé par la technique Sol-Gel suivi d'un recuit d'activation. Typiquement, la température de recuit est de 140° pour les PVDF et de 700°C pour les Perovskites. Ici, l'épaisseur de la couche 26 est comprise entre 10 nm et 5 µm.

Ensuite, lors d'une étape 94, l'électrode 24 est déposée (figure 10). L'électrode 24 est typiquement déposée selon les mêmes méthodes que celles décrites pour l'étape 90.

Lors d'une étape 96, on procède à une gravure partielle de l'électrode 24 pour atteindre la couche 26 (figure 11). Par exemple, cette gravure peut se faire par gravure sèche CHF₃/O₂ ou SF6 ou par usinage ionique ou par gravure chimique.

Enfin, lors d'une étape 98, on grave partiellement la couche 26 pour mettre à nu l'électrode 23. Comme précédemment, cette gravure partielle peut être réalisée par une gravure sèche ou un usinage ionique ou une gravure chimique. Il est alors possible d'appliquer une différence de potentiels entre les électrodes 23 et 24. Eventuellement, à la fin de cette étape 98, la capacité du condensateur 8 ainsi réalisée est testée.

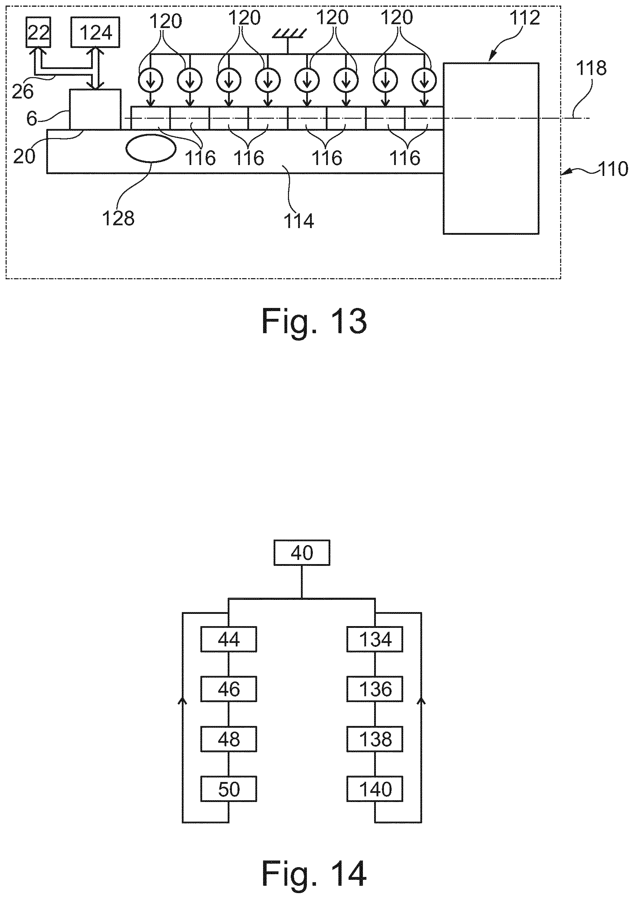

La figure 13 représente un système électronique 110 identique au système 4 sauf que les condensateurs sont utilisés pour accélérer le transfert de chaleur du composant 6 vers un puits 112 de chaleur. Par exemple, le puits 112 est un radiateur qui échange de la chaleur par convection avec un milieu extérieur. Le puits 112 est thermiquement raccordé à la face 20 du composant 6 par un conduit 114 de chaleur. D'un côté, le conduit 114 est directement en contact mécanique et thermique avec la face 20. D'un autre côté opposé, il est directement en contact mécanique et thermique avec le puits 112. Par exemple, dans ce mode de réalisation, le conduit 114 est formé par le substrat en silicium sur lequel le composant 6 a été réalisé.

Entre le composant 6 et le puits 112 sont disposés N condensateurs 116 alignés les uns à côté des autres le long d'une ligne droite 118 passant par le composant 6 et le puits 112. Pour simplifier la figure 13, seuls huit condensateurs 116 sont représentés. Toutefois, N est un entier supérieur ou égal à deux et, de préférence, supérieur ou égal à 8, 16 ou 32 ou 100. De préférence, le nombre de condensateurs 116 alignés le long de la droite 118 est plus dense que 100 ou 1000 condensateurs 116 par centimètre.

Ici, tous les condensateurs 116 sont identiques aux condensateurs 8. L'électrode 23 de chacun de ces condensateurs 116 est directement mécaniquement et thermiquement en contact avec le conduit 114 de chaleur. Cette électrode 23 est raccordée à la masse. Pour simplifier la figure 13, ce raccordement n'a pas été représenté.

Une source 120 de tension est associée à chaque condensateur 116 pour appliquer une différence de potentiels commandable entre ses électrodes 23 et 24. Chaque source 120 est par exemple identique à la source 10.

L'unité 112 de commande est remplacée par une unité 124 de commande des différentes sources 120 de tension. L'unité 124 est identique à l'unité 12 mais programmée pour exécuter le procédé de la figure 14. Pour simplifier la figure, les connexions entre l'unité 124 et chacune des sources 120 n'ont pas été représentées.

Le fonctionnement du système 110 va maintenant être décrit en référence au procédé de la figure 14. Le procédé de la figure 14 est identique au procédé de la figure 2 sauf que les étapes 54 à 60 sont remplacées, respectivement, par des étapes 134 à 140.

L'étape 134 est identique à l'étape 54 sauf que l'on commande les sources 120 les unes après les autres en allant de la source 120 raccordée au condensateur 116 le plus proche du composant 6 jusqu'à la source 120 raccordée au condensateur 116 le plus éloigné du composant 6. Ici, la commande d'une source 120 pour diminuer la différence de potentiels entre les électrodes 23 et 24 du condensateur auquel elle est raccordée consiste à faire chuter brusquement la différence de potentiels de sa valeur DDP1 à sa valeur DDP2. Par brusquement, on désigne une variation de la différence de potentiels entre les valeurs DDP1 et DDP2 réalisée en moins de 100ms ou en moins d'1 ms.

L'intervalle ΔC de temps entre l'instant où l'on commence à commander une source 120 et l'instant où l'on commence à commander une source 120 raccordée au condensateur 116 immédiatement consécutif le long de la ligne 118 est choisi supérieur à un centième de la durée de l'intervalle IDₒₙ ou de l'estimation EDₒₙ. De préférence, la durée de l'intervalle ΔC est inférieure à 100 fois la durée de l'intervalle IDₒₙ ou de l'estimation EDₒₙ.

Quand on diminue la différence de potentiels entre les électrodes 23 et 24 d'un condensateur 116, celui-ci refroidit le conduit 114 à un emplacement situé immédiatement sous son électrode 23. L'endroit refroidi crée un point froid 128 représenté par une ellipse sur la figure 13. Le point froid 128 attire la chaleur dissipée par le composant 6. Ensuite, quand on commande la source 120 suivante, le point froid se déplace en direction du puits 112. La chaleur dissipée par le composant 6 se déplace alors vers la nouvelle position du point froid 128. En commandant successivement les sources 120 comme décrits ici, le point froid 128 se déplace du composant 6 jusqu'au puits 112. Ceci permet d'accélérer le transfert de chaleur du composant 6 vers le puits 112.

Lors de l'étape 136, quand la différence de potentiels entre les électrodes 23 et 24 d'un condensateur 116 atteint la valeur DDP2, l'unité 24 commande la source 120 raccordée à ce condensateur pour maintenir cette différence de potentiels tant qu'aucun événement de désactivation du composant 6 n'est reçu.

L'étape 138 consiste à réaliser l'étape 58 en même temps pour chacun des condensateurs 116. Toutefois, ici, à titre d'illustration, la commande de la source 120 consiste à passer brusquement de la valeur DDP2 à la valeur DDP1 de la différence de potentiels.

Lors de l'étape 140, quand la différence de potentiels entre les électrodes 23 et 24 d'un condensateur 116 atteint la valeur DDP1, l'unité 24 commande la source 120 raccordée à ce condensateur pour maintenir cette différence de potentiels tant qu'aucun basculement du composant 6 dans l'état actif n'est détecté.

Le procédé retourne alors à l'étape 134.

De nombreux autres modes de réalisation sont possibles. Par exemple, d'autres matériaux électrocaloriques que ceux décrits précédemment peuvent convenir. Ainsi, le matériau électrocalorique positif peut être remplacé par un matériau électrocalorique négatif, c'est-à-dire un matériau électrocalorique dont la température décroît quand une différence de potentiels est appliquée à ce matériau entre les électrodes. Dans ce cas, quand le composant est dans l'état passif, aucune différence de potentiels n'est appliquée au condensateur. Quand le composant bascule de l'état passif vers l'état actif, on applique une différence de potentiels pour diminuer sa température. En d'autre terme les valeurs DDP1 et DDP2 sont inversées dans le cas d'un matériau électrocalorique négatif. Ainsi, tout ce qui est décrit dans le cas particulier du matériau électrocalorique positif peut être transposé au cas du matériau électrocalorique négatif.

La fonction monotone utilisée pour faire varier la différence de potentiels entre les électrodes 23 et 24 peut être une droite ou être remplacée par une fonction non linéaire. Par exemple, une fonction polynomiale d'ordre 2 ou supérieure peut être utilisée.

La durée de l'intervalle ΔTₒₙ ou ΔT_{off} peut ne pas être directement proportionnelle aux estimations EDₒₙ et ED_{off}. Par exemple, la durée de l'intervalle ΔTₒₙ est reliée à l'estimation EDₒₙ par une relation non linéaire.

L'estimation EDₒₙ n'est pas nécessairement une constante préenregistrée. Par exemple, la valeur de l'estimation EDₒₙ peut être réactualisée à chaque mise à jour d'un historique des précédentes durées des intervalles IDₒₙ observées. L'estimation EDₒₙ peut aussi être réactualisée au cours de l'intervalle IDₒₙ de sorte que la durée ΔTₒₙ est elle-même réactualisée au cours de l'intervalle IDₒₙ. Ces différentes variantes pour une fonction monotone utilisée pendant l'intervalle IDₒₙ peuvent aussi être transposées à la fonction monotone utilisée pendant l'intervalle ID_{off} en remplaçant ΔTₒₙ par ΔT_{off}, EDₒₙ par ED_{off}, et en changeant le sens de variation de la fonction monotone.

D'autres modes de détection du passage de l'état actif vers l'état passif et vice versa peuvent être utilisés. Par exemple, en variante, seule la température mesurée du composant 6 est utilisée. Par exemple, lors de l'étape 54, le passage de l'état passif à l'état actif est détecté lorsque la température mesurée dépasse le seuil T₁. De façon similaire, lors de l'étape 58, le passage de l'état actif à l'état passif est détecté lorsque la température mesurée descend en dessous du seuil T₁. A l'inverse, il est aussi possible d'utiliser seulement la quantité Q de chaleur produite par seconde pour détecter le basculement entre les états passif et actif.

D'autres manières d'acquérir la quantité Q de chaleur produite pas seconde sont possibles. Par exemple, un capteur de la quantité de chaleur produite par seconde par le composant 6 peut être utilisé.

Des seuils prédéterminés S₂, différents de seuils prédéterminés S₁, peuvent être utilisés pour détecter le basculement de l'état actif vers l'état passif tandis que les seuils S₁ sont utilisés pour détecter le basculement de l'état passif vers l'état actif. De préférence, les seuils S₁ sont strictement supérieurs aux seuils S₂. Toutefois, les seuils S₁ et S₂ peuvent aussi être égaux comme décrit précédemment dans le cas particulier où les seuils S₁ et S₂ correspondent chacun aux seuils Q₁, T₁. En variante, la valeur de la différence de potentiels appliquée pendant, respectivement, les intervalles ΔTₒₙ et ΔT_{off} peut aussi être fonction de la température mesurée. Par exemple, plus la température mesurée est importante, plus l'on fait varier rapidement la différence de potentiels entre les électrodes 23 et 24.

D'autres modes de réalisation du condensateur 8 sont possibles. Par exemple, un tel condensateur peut aussi être réalisé comme décrit dans l'article A1. Dans cet article, le condensateur est réalisé selon le procédé traditionnel de fabrication des condensateurs multicouches. Le condensateur 8 peut aussi être réalisé comme les condensateurs films formés en enroulant un film multicouche réalisé par la superposition d'une couche métallique, de la couche diélectrique et d'une autre couche métallique. Les couches métalliques correspondent aux électrodes. Dans ce cas, l'épaisseur de la couche diélectrique est souvent supérieure à 2 µm ou 5 µm et, de préférence, inférieure à 20 µm ou 15 µm.

L'électrode 23 du condensateur 8 n'est pas nécessairement directement en contact avec la face 20. Par exemple, l'électrode 23 peut être en contact thermique avec la face 20 par l'intermédiaire d'un ou plusieurs matériaux bons conducteurs thermiques.

En variante, les différents condensateurs 116 ne sont pas tous identiques. Par exemple, les condensateurs 116 peuvent différer les uns des autres par leur propriété thermique tel que leur capacité thermique massique, leur volume, la nature du matériau électrocalorique, ...etc. Dans une autre variante, les fonctions monotones pour faire varier la différence de potentiels entre les valeurs DDP1 et DDP2 ne sont pas toutes les mêmes d'un condensateur à l'autre.

Le composant 6 n'est pas nécessairement un circuit intégré. Par exemple, le composant 6 peut être un composant électronique passif tel qu'une résistance, un condensateur ou une inductance. Le composant 6 peut aussi être un composant électrique plus complexe tel qu'un transformateur.

Le terminal 2 n'est pas nécessaire un terminal mobile.

Ce qui vient d'être décrit s'applique au cas où la température Tₐ est très différente de 25°C. Par exemple dans d'autre application, la température Tₐ dépasse 100°C ou, au contraire, est négative.

## Revendications

1. Procédé de limitation des variations de température d'un composant électrique équipé d'une face d'évacuation de la chaleur, ce procédé comportant :
a) l'acquisition de la valeur d'une grandeur physique représentative de la température du composant électrique et/ou d'une grandeur physique représentative de la quantité de chaleur produite par seconde par ce composant électrique,
b) la détection, à partir de la ou des valeurs de grandeurs physiques acquises, du basculement (46, 50) du composant électrique entre :
- un état actif dans lequel le composant électrique doit être refroidi, et
- un état passif dans lequel le composant électrique peut être réchauffé,
**caractérisé en ce que** le procédé comprend également les étapes de
c) en réponse à la détection du basculement de l'état passif vers l'état actif, la commande (54, 56 ; 134, 136) d'une source de tension pour faire varier une différence de potentiels entre une première et une seconde électrodes d'un condensateur, d'une première valeur (DDP1) jusqu'à une seconde valeur (DDP2) puis, si cette seconde valeur est atteinte avant la détection du basculement suivant du composant électrique de l'état actif vers l'état passif, pour maintenir cette seconde valeur de la différence de potentiels tant que le composant électrique est dans l'état actif,
les électrodes étant isolées mécaniquement et électriquement l'une de l'autre par une couche en matériau diélectrique électrocalorique, la première électrode étant en contact thermique par conduction avec la face d'évacuation de la chaleur du composant électrique et les première et seconde valeurs étant telles que cette variation de la différence de potentiels provoque une absorption de chaleur par la couche en matériau diélectrique électrocalorique,
d) en réponse à la détection du basculement de l'état actif vers l'état passif, la commande (58, 60; 138, 140) de la source de tension pour faire varier la différence de potentiels, entre les première et seconde électrodes du condensateur, de la seconde valeur (DDP2) jusqu'à la première valeur (DDP1), puis, si cette première valeur est atteinte avant la détection du basculement suivant du composant électrique de l'état passif vers l'état actif, pour maintenir cette première valeur de la différence de potentiels tant que le composant électrique est dans l'état passif.

2. Procédé selon la revendication 1, dans lequel le procédé comporte :
- l'acquisition d'une estimation de la durée de l'état actif à venir, et
- lors de l'étape b), la commande (54) de la source de tension pour passer suivant une fonction monotone, dans un intervalle de temps donné, de la première valeur (DDP1) à la seconde valeur (DDP2) de la différence de potentiels, et
- l'ajustement de la durée de l'intervalle de temps donné en fonction de l'estimation acquise de la durée de l'état actif.

3. Procédé selon l'une quelconque des revendications précédentes, dans lequel le procédé comporte :
- lors de l'étape a), l'acquisition de la valeur d'une grandeur physique représentative de la température du composant électrique ou de la quantité de chaleur produite par seconde par ce composant électrique, et
- la détection du basculement de l'état passif vers l'état actif en comparant cette valeur acquise à un premier seuil prédéterminé, et
- la détection du basculement de l'état actif vers l'état passif en comparant cette valeur acquise à un second seuil prédéterminé, les premier et second seuils étant égaux ou différents.

4. Procédé selon l'une quelconque des revendications précédentes, dans lequel la valeur absolue de la première valeur de la différence de potentiels est strictement supérieure à la valeur absolue de la seconde valeur de la différence de potentiels si le matériau électrocalorique est un matériau électrocalorique positif, et la valeur absolue de la première valeur de la différence de potentiels est strictement inférieure à la valeur absolue de la seconde valeur de la différence de potentiels si le matériau électrocalorique est un matériau électrocalorique négatif.

5. Procédé selon l'une quelconque des revendications précédentes, dans lequel, dans l'état passif, la température du composant électrique retombe, sans l'aide du condensateur, en-dessous d'une température maximale de fonctionnement spécifiée pour ce composant électrique.

6. Support (36) d'enregistrement d'informations, **caractérisé en ce qu'**il comporte des instructions pour l'exécution d'un procédé conforme à l'une quelconque des revendications précédentes, lorsque ces instructions sont exécutées par un calculateur électronique.

7. Système électronique comportant :
- un composant électrique (6) équipé d'une face (20) d'évacuation de la chaleur, ce composant étant apte à basculer, en réponse à une commande, entre :
• un état actif dans lequel le composant électrique doit être refroidi, et
• un état passif dans lequel le composant électrique peut être réchauffé,
- un refroidisseur pilotable
- une première source (10; 120) de tension apte à appliquer au refroidisseur pilotable une différence de potentiels commandable,
- une unité (12; 124) de commande de cette source de tension de manière à limiter les variations de température du composant électrique, et programmée pour acquérir la valeur d'une grandeur physique représentative de la température du composant électrique et/ou d'une grandeur physique représentative de la quantité de chaleur produite par seconde par ce composant électrique **caractérisé en ce que** :
- le refroidisseur pilotable est un premier condensateur (8;116) comportant une première et une seconde électrodes et une couche en matériau diélectrique isolant mécaniquement et électriquement les deux électrodes l'une de l'autre, la première électrode étant en contact thermique par conduction avec la face d'évacuation de la chaleur du composant électrique, le matériau diélectrique est aussi un matériau électrocalorique, et
- l'unité de commande est programmée pour :
• détecter, à partir de la ou des valeurs de grandeurs physiques acquises, le basculement du composant électrique entre ses états actif et passif,
• en réponse à la détection du basculement de l'état passif vers l'état actif, commander la source de tension pour faire varier la différence de potentiels entre les première et une seconde électrodes du condensateur, d'une première valeur (DDP1) jusqu'à une seconde valeur (DDP2) puis, si cette seconde valeur est atteinte avant la détection du basculement suivant du composant électrique de l'état actif vers l'état passif, pour maintenir cette seconde valeur de la différence de potentiels tant que le composant électrique est dans l'état actif, et
• en réponse à la détection du basculement de l'état actif vers l'état passif, commander la source de tension pour faire varier la différence de potentiels, entre les première et seconde électrodes du condensateur, de la seconde valeur (DDP2) jusqu'à la première valeur (DDP1), puis, si cette première valeur est atteinte avant la détection du basculement suivant du composant électrique de l'état passif vers l'état actif, pour maintenir cette première valeur de la différence de potentiels tant que le composant électrique est dans l'état passif.

8. Système selon la revendication 7, dans lequel le système comporte :
- un puits (112) de chaleur,
- un conduit (114) de chaleur directement en contact mécanique et thermique, d'un côté, avec la face (20) d'évacuation de la chaleur du composant électrique et, de l'autre côté, avec le puits de chaleur,
- un second condensateur (116) comportant une première et une seconde électrodes et une couche en matériau électrocalorique et diélectrique isolant mécaniquement et électriquement les deux électrodes l'une de l'autre, les premières électrodes des premier et second condensateurs étant disposées en contact thermique et mécanique directement avec le conduit de chaleur, la première électrode du second condensateur étant disposée entre la première électrode du premier condensateur et le puits de chaleur,
- une seconde source (120) de tension apte à appliquer entre les deux électrodes du second condensateur une différence de potentiels commandable, et
- l'unité (124) de commande est programmée pour commander la seconde source de tension pour refroidir le conduit de chaleur avec le second condensateur en réponse à la détection du basculement du composant électrique de l'état passif vers l'état actif mais avec un décalage temporel d'au moins 10ms par rapport à l'instant où l'unité commande la première source de tension pour refroidir ce même conduit de chaleur par le premier condensateur.

9. Système selon l'une quelconque des revendications 7 à 8, dans lequel l'épaisseur de la couche (26) en matériau diélectrique électrocalorique est inférieure à 50 µm et, de préférence, inférieure à 2 µm.

10. Système selon l'une quelconque des revendications 7 à 9, dans lequel le composant électrique (6) est un circuit intégré comportant au moins un commutateur électronique.

## Patentansprüche

1. Verfahren zur Begrenzung der Temperaturschwankungen eines elektrischen Bauteils, das mit einer Wärmeabfuhrseite ausgestattet ist, wobei dieses Verfahren aufweist:
a) die Erfassung des Werts einer physikalischen Größe, die für die Temperatur des elektrischen Bauteils repräsentativ ist, und/oder einer physikalischen Größe, die für die von diesem elektrischen Bauteil pro Sekunde erzeugte Wärmemenge repräsentativ ist,
b) die Erkennung, ausgehend von dem Wert oder den Werten erfasster physikalischer Größen, des Umschaltens (46, 50) des elektrischen Bauteils zwischen:
- einem aktiven Zustand, in dem das elektrische Bauteil gekühlt werden muss, und
- einem passiven Zustand, in dem das elektrische Bauteil wieder erwärmt werden kann,
**dadurch gekennzeichnet, dass** das Verfahren ebenfalls die Schritte enthält
c) als Reaktion auf die Erkennung des Umschaltens vom passiven Zustand in den aktiven Zustand, die Steuerung (54, 56; 134, 136) einer Spannungsquelle, um eine Potentialdifferenz zwischen einer ersten und einer zweiten Elektrode eines Kondensators von einem ersten Wert (DDP1) bis zu einem zweiten Wert (DDP2) zu variieren, dann, wenn dieser zweite Wert vor der Erkennung des folgenden Umschaltens des elektrischen Bauteils vom aktiven Zustand in den passiven Zustand erreicht wird, um diesen zweiten Wert der Potentialdifferenz beizubehalten, so lange das elektrische Bauteil im aktiven Zustand ist,
wobei die Elektroden durch eine Schicht aus elektrokalorischem dielektrischem Material mechanisch und elektrisch voneinander isoliert sind,
wobei die erste Elektrode mit der Wärmeabfuhrseite des elektrischen Bauteils in Wärmeleitkontakt ist, und der erste und der zweite Wert so sind, dass diese Variation der Potentialdifferenz eine Wärmeabsorption durch die Schicht aus elektrokalorischem dielektrischem Material bewirkt,
d) als Reaktion auf die Erkennung des Umschaltens vom aktiven Zustand in den passiven Zustand, die Steuerung (58, 60; 138, 140) der Spannungsquelle, um die Potentialdifferenz zwischen der ersten und der zweiten Elektrode des Kondensators vom zweiten Wert (DDP2) bis zum ersten Wert (DDP1) zu variieren, dann, wenn dieser erste Wert vor der Erkennung der folgenden Umschaltung des elektrischen Bauteils vom passiven Zustand in den aktiven Zustand erreicht wird, um diesen ersten Wert der Potentialdifferenz beizubehalten, so lange das elektrische Bauteil im passiven Zustand ist.

2. Verfahren nach Anspruch 1, wobei das Verfahren aufweist:
- die Erfassung einer Schätzung der Dauer des kommenden aktiven Zustands, und
- im Schritt b), die Steuerung (54) der Spannungsquelle, um gemäß einer monotonen Funktion in einem gegebenen Zeitintervall vom ersten Wert (DDP1) zum zweiten Wert (DDP2) der Potentialdifferenz überzugehen, und
- die Anpassung der Dauer des gegebenen Zeitintervalls abhängig von der erfassten Schätzung der Dauer des aktiven Zustands.

3. Verfahren nach einem der vorhergehenden Ansprüche, wobei das Verfahren aufweist:
- im Schritt a), die Erfassung des Werts einer physikalischen Größe, die für die Temperatur des elektrischen Bauteils oder die von diesem elektrischen Bauteil pro Sekunde erzeugte Wärmemenge repräsentativ ist, und
- die Erkennung des Umschaltens vom passiven Zustand in den aktiven Zustand, indem dieser erfasste Wert mit einer ersten vorbestimmten Schwelle verglichen wird, und
- die Erkennung des Umschaltens vom aktiven Zustand in den passiven Zustand, indem dieser erfasste Wert mit einer zweiten vorbestimmten Schwelle verglichen wird, wobei die erste und die zweite Schwelle gleich oder unterschiedlich sind.

4. Verfahren nach einem der vorhergehenden Ansprüche, wobei der Absolutwert des ersten Werts der Potentialdifferenz strikt höher als der Absolutwert des zweiten Werts der Potentialdifferenz ist, wenn das elektrokalorische Material ein positives elektrokalorisches Material ist, und der Absolutwert des ersten Werts der Potentialdifferenz strikt niedriger als der Absolutwert des zweiten Werts der Potentialdifferenz ist, wenn das elektrokalorische Material ein negatives elektrokalorische Material ist.

5. Verfahren nach einem der vorhergehenden Ansprüche, wobei, im passiven Zustand, die Temperatur des elektrischen Bauteils ohne die Hilfe des Kondensators unter eine für dieses elektrische Bauteil spezifizierte maximale Betriebstemperatur zurückfällt.

6. Datenaufzeichnungsträger (36), **dadurch gekennzeichnet, dass** er Anweisungen zur Ausführung eines Verfahren nach einem der vorhergehenden Ansprüche aufweist, wenn diese Anweisungen von einem elektronischen Rechner ausgeführt werden.

7. Elektronisches System, das aufweist:
- ein elektrisches Bauteil (6), das mit einer Wärmeabfuhrseite (20) ausgestattet ist, wobei dieses Bauteil als Reaktion auf eine Steuerung umschalten kann zwischen:
• einem aktiven Zustand, in dem das elektrische Bauteil gekühlt werden muss, und
• einem passiven Zustand, in dem das elektrische Bauteil wieder erwärmt werden kann,
- einen steuerbaren Kühler,
- eine erste Spannungsquelle (10; 120), die an den steuerbaren Kühler eine steuerbare Potentialdifferenz anlegen kann,
- eine Steuereinheit (12; 124) dieser Spannungsquelle, um die Temperaturschwankungen des elektrischen Bauteils zu begrenzen, und programmiert, um den Wert einer physikalischen Größe, die für die Temperatur des elektrischen Bauteils repräsentativ ist, und/oder einer physikalischen Größe zu erfassen, die für die von diesem elektrischen Bauteil pro Sekunde erzeugte Wärmemenge repräsentativ ist, **dadurch gekennzeichnet, dass**:
- der steuerbare Kühler ein erster Kondensator (8;116) ist, der eine erste und eine zweite Elektrode und eine Schicht aus dielektrischem Material aufweist, das die zwei Elektroden mechanisch und elektrisch voneinander isoliert, wobei die erste Elektrode mit der Wärmeabfuhrseite des elektrischen Bauteils in Wärmeleitkontakt ist, wobei das dielektrische Material auch ein elektrokalorisches Material ist, und
- die Steuereinheit programmiert ist, um:
• ausgehend von dem Wert oder den Werten erfasster physikalischer Größen das Umschalten des elektrischen Bauteils zwischen seinem aktiven und passiven Zustand zu erkennen,
• als Reaktion auf die Erkennung des Umschaltens vom passiven Zustand in den aktiven Zustand, die Spannungsquelle zu steuern, um die Potentialdifferenz zwischen der ersten und der zweiten Elektrode des Kondensators von einem ersten Wert (DDP1) bis zu einem zweiten Wert (DDP2) zu variieren, dann, wenn dieser zweite Wert vor der Erkennung des folgenden Umschaltens des elektrischen Bauteils vom aktiven Zustand in den passiven Zustand erreicht wird, um diesen zweiten Wert der Potentialdifferenz beizubehalten, so lange das elektrische Bauteil im aktiven Zustand ist, und
• als Reaktion auf die Erkennung des Umschaltens vom aktiven Zustand in den passiven Zustand, die Spannungsquelle zu steuern, um die Potentialdifferenz zwischen der ersten und der zweiten Elektrode des Kondensators vom zweiten Wert (DDP2) bis zum ersten Wert (DDP1) zu variieren, dann, wenn dieser erste Wert vor der Erkennung des folgenden Umschaltens des elektrischen Bauteils vom passiven Zustand in den aktiven Zustand erreicht wird, um diesen ersten Wert der Potentialdifferenz beizubehalten, so lange das elektrische Bauteil im passiven Zustand ist.

8. System nach Anspruch 7, wobei das System aufweist:
- eine Wärmesenke (112),
- eine Wärmeleitung (114), die einerseits mit der Wärmeabfuhrseite (20) des elektrischen Bauteils und andererseits mit der Wärmesenke in direktem mechanischen und elektrischen Kontakt ist,
- einen zweiten Kondensator (116), der eine erste und eine zweite Elektrode und eine Schicht aus elektrokalorischem und dielektrischem Material aufweist, die die zwei Elektroden mechanisch und elektrisch voneinander isoliert, wobei die ersten Elektroden der ersten und zweiten Kondensatoren in direktem thermischem und mechanischem Kontakt mit der Wärmeleitung angeordnet sind, wobei die erste Elektrode des zweiten Kondensators zwischen der ersten Elektrode des ersten Kondensators und der Wärmesenke angeordnet ist,
- eine zweite Spannungsquelle (120), die eine steuerbare Potentialdifferenz zwischen die zwei Elektroden des zweiten Kondensators anlegen kann, und
- die Steuereinheit (124) programmiert ist, um die zweite Spannungsquelle zu steuern, um die Wärmeleitung mit dem zweiten Kondensator als Reaktion auf die Erkennung des Umschaltens des elektrischen Bauteils vom passiven Zustand in den aktiven Zustand zu kühlen, aber mit einer Zeitverzögerung von mindestens 10ms bezüglich des Zeitpunkts, in dem die Einheit die erste Spannungsquelle steuert, um diese gleiche Wärmeleitung durch den ersten Kondensator zu kühlen.

9. System nach einem der Ansprüche 7 bis 8, wobei die Dicke der Schicht (26) aus elektrokalorischem dielektrischem Material geringer als 50 µm und vorzugsweise geringer als 2 µm ist.

10. System nach einem der Ansprüche 7 bis 9, wobei das elektrische Bauteil (6) ein integrierter Schaltkreis ist, der mindestens einen elektronischen Schalter aufweist.

## Claims

1. Method for limiting the variation in the temperature of an electrical component equipped with a heat evacuation face, this method comprising:
a) acquiring the value of a physical quantity representative of the temperature of the electrical component and/or of a physical quantity representative of the amount of heat produced per second by this electrical component; and
b) detecting, based on the one or more values of the physical quantities acquired, when the electrical component switches (46, 50) between:
- an active state in which the electrical component must be cooled, and
- a passive state in which the electrical component may be heated,
**characterised in that** the method also comprises steps of:
c) in response to detection of the switch from the passive state to the active state, controlling (54, 56; 134, 136) a voltage source to vary a potential difference between first and second electrodes of a capacitor from a first value (DDP1) to a second value (DDP2) and then, if this second value is reached before the next time the electrical component is detected to switch from the active state to the passive state, to maintain this second potential difference value provided the electrical component is in the active state,
the electrodes being mechanically and electrically insulated from each other by a layer of electrocaloric dielectric material, the first electrode making conductive thermal contact with the heat evacuation face of the electrical component and the first and second values being such that this variation in potential difference causes heat to be absorbed by the electrocaloric dielectric layer; and
d) in response to detection of the switch from the active state to the passive state, controlling (58, 60; 138, 140) the voltage source to vary the potential difference between the first and second electrodes of the capacitor from the second value (DDP2) to the first value (DDP1) and then, if this first value is reached before the next time the electrical component is detected to switch from the passive state to the active state, to maintain this first potential difference value provided the electrical component is in the passive state.

2. Method according to Claim 1, in which the method comprises:
- acquiring an estimation of the duration of the next active state; and
- in step b), controlling (54) the voltage source so that the potential difference passes, as a monotonic function, in a given time interval, from the first value (DDP1) to the second value (DDP2); and
- adjusting the duration of the given time interval depending on the estimation acquired of the duration of the active state.

3. Method according to either one of the preceding claims, in which the method comprises:
- in step a), acquiring the value of a physical quantity representative of the temperature of the electrical component or of the amount of heat produced per second by this electrical component; and
- detecting a switch from the passive state to the inactive state by comparing this acquired value with a first preset threshold; and
- detecting a switch from the active state to the passive state by comparing this acquired value with a second preset threshold, the first and second thresholds being equal or different.

4. Method according to any one of the preceding claims, in which the absolute value of the first potential difference value is strictly higher than the absolute value of the second potential difference value if the electrocaloric material is a positive electrocaloric material, and the absolute value of the first potential difference value is strictly lower than the absolute value of the second potential difference value if the electrocaloric material is a negative electrocaloric material.

5. Method according to any one of the preceding claims, in which, in the passive state, the temperature of the electrical component drops, without using the capacitor, below a maximum operating temperature specified for this electrical component.

6. Data storage medium (36), **characterised in that** it comprises instructions for executing a method according to any one of the preceding claims, these instructions being executed by a computer.

7. Electronic system comprising:
- an electrical component (6) equipped with a heat evacuation face (20), this component being able to switch, in response to a control signal, between:
• an active state in which the electrical component must be cooled, and
• a passive state in which the electrical component may be heated;
- a controllable cooler;
- a first voltage source (10; 120) able apply to the controllable cooler a controllable potential difference; and
- a unit (12; 124) for controlling this voltage source in order to limit the variation in the temperature of the electrical component, and programmed to acquire the value of a physical quantity representative of the temperature of the electrical component and/or of a physical quantity representative of the amount of heat produced per second by this electrical component;
**characterized in that**:
- the controllable cooler is a first capacitor (8, 116) comprising first and second electrodes (23, 24) and a layer (26) made of a dielectric material mechanically and electrically insulating the two electrodes from each other, the first electrode making conductive thermal contact with the heat evacuation face of the electrical component;
- the dielectric material is also an electrocaloric material; and
- the control unit is programmed:
• to detect, based on the one or more values of the physical quantities acquired, when the electrical component switches between its active and passive states:
• in response to detection of the switch from the passive state to the active state, to control the voltage source to vary the potential difference between the first and second electrodes of the capacitor from a first value (DDP1) to a second value (DDP2) and then, if this second value is reached before the next time the electrical component is detected to switch from the active state to the passive state, to maintain this second potential difference value provided the electrical component is in the active state; and
• in response to detection of the switch from the active state to the passive state, to control the voltage source to vary the potential difference between the first and second electrodes of the capacitor from the second value (DDP2) to the first value (DDP1) and then, if this first value is reached before the next time the electrical component is detected to switch from the passive state to the active state, to maintain this first potential difference value provided the electrical component is in the passive state.

8. System according to Claim 7, in which the system comprises:
- a heat sink (112);
- a heat pipe (114) making direct thermal and mechanical contact, at one end, with the heat evacuation face (20) of the electrical component and, at the other end, with the heat sink;
- a second capacitor (116) comprising first and second electrodes and an electrocaloric dielectric layer mechanically and electrically insulating the two electrodes from each other, the first electrodes of the first and second capacitors being placed in direct thermal and mechanical contact with the heat pipe, the first electrode of the second capacitor being placed between the first electrode of the first capacitor and the heat sink;
- a second voltage source (120) able to apply a controllable potential difference between the two electrodes of the second capacitor; and
- the control unit (124) is programmed to control the second voltage source so that the heat pipe is cooled with the second capacitor when the electrical component is detected to switch from the passive state to the active state but with a delay of at least 10 ms relative to the point in time when the unit controls the first voltage source in order to cool said heat pipe with the first capacitor.

9. System according to any one of Claims 7 to 8, in which the electrocaloric dielectric layer (26) is less than 50 µm in thickness and preferably less than 2 µm in thickness.

10. System according to any one of Claims 7 to 9, in which the electrical component (6) is an integrated circuit comprising at least one electronic switch.
